# EUROPEAN PATENT APPLICATION

(11) **EP 4 708 699 A1**
(43) Date of publication of application: **11.03.2026**
(21) Application number: 24925452.5
(22) Date of filing: 15.08.2024
(51) Int. Cl.: H03M 1/46

(54) **ANALOG-TO-DIGITAL CONVERSION CIRCUIT, CHIP, AND RECORDING DEVICE**

(30) Priority: 19.02.2024 CN 202410185574
(71) Applicant: Actions Technology Co., Ltd., Zhuhai, Guangdong 519085 (CN)
(72) Inventor: XIONG, Jiang, Zhuhai, Guangdong 519085 (CN); CHEN, Xujian, Zhuhai, Guangdong 519085 (CN)
(74) Representative: Metida
(86) International application number: PCT/CN2024/112452
(87) International publication number: WO 2025/175710

(57) **Abstract**

An analog-to-digital conversion circuit, a chip, and a recording device are provided. The analog-to-digital conversion circuit includes a main path module, a dynamic range enhancement module, and a dynamic digital-to-analog conversion module. The main path module converts an analog signal and an analog feedback signal into a digital signal to be processed, outputs the digital signal to be processed to the dynamic range enhancement module, and obtains a digital signal output according to the digital signal to be processed and the digital gain signal. The dynamic range enhancement module performs dynamic quantization processing on the digital signal to be processed to obtain at least one control signal and generate the digital gain signal. The dynamic digital-to-analog conversion module dynamically controls on and off of each of DAC elements in a digital-to-analog conversion array according to the at least one control signal and generates the analog feedback signal.

## Description

### TECHNICAL FIELD

The present disclosure relates to a field of analog-to-digital conversion technology, and in particular to an analog-to-digital conversion circuit, a chip, and a recording device.

### BACKGROUND

Most current recording devices use a microphone thereof to capture a sound signal, which is then converted into a weak electrical signal. The weak electrical signal is then amplified by a programmable gain amplifier (PGA) and output to an analog-to-digital converter (ADC). The ADC converts an amplified electrical signal into a digital signal. Finally, the digital signal undergoes digital processing to form a final output signal.

In an entire signal processing path, the PGA and ADC are primary sources of noise, impacting final recording performance. Generally speaking, a low-noise PGA is easier to produce than a low-noise ADC. Therefore, when low-noise performance of the ADC is not satisfied, performance of the entire signal processing path may be improved by dynamically adjusting a gain of the PGA, leading to better recording performance. However, such an arrangement significantly increases power consumption and a size of the entire signal processing path.

In the related art, a gain adjustment inside the ADC is achieved by adjusting an input resistor connected to an input port of the ADC. However, by adopting the method, an operational amplifier (OPA) needs to be connected between the microphone and the ADC. The OPA provides a low-impedance output resistance path and isolates an effect of equivalent output resistance of the microphone on the gain. However, an introduction of the OPA leads to an increase in the power consumption of a corresponding recording device.

### SUMMARY

In view of problems in the related art, the present disclosure provides an analog-to-digital conversion circuit, a chip, and a recording device to solve the problems.

In a first aspect, the present disclosure provides an analog-to-digital conversion circuit. The analog-to-digital conversion circuit includes a main path module, a dynamic range enhancement module, and a dynamic digital-to-analog conversion module. The dynamic digital-to-analog conversion module includes a digital-to-analog conversion array.

The main path module is configured to convert an analog signal and an analog feedback signal from the dynamic digital-to-analog conversion module into a digital signal to be processed. The main path module is configured to output the digital signal to be processed to the dynamic range enhancement module. The main path module is further configured to obtain a digital signal output according to the digital signal to be processed and a digital gain signal from the dynamic range enhancement module.

The dynamic range enhancement module is configured to perform dynamic quantization processing on the digital signal to be processed to obtain at least one control signal. The dynamic range enhancement module is configured to output the at least one control signal to the dynamic digital-to-analog conversion module. The dynamic range enhancement module is further configured to generate the digital gain signal and output the digital gain signal to the main path module.

The dynamic digital-to-analog conversion module is configured to dynamically control on and off of each of digital-to-analog converter (DAC) elements in the digital-to-analog conversion array according to the at least one control signal and output the analog feedback signal to the main path module.

In one optional embodiment, the main path module includes a loop filter and a quantizer.

The loop filter is configured to perform integral filtering processing on the analog signal and the analog feedback signal to obtain a first filtered signal and output the first filtered signal to the quantizer.

The quantizer is configured to perform quantization processing on the first filtered signal to obtain the digital signal to be processed and output the digital signal to the dynamic range enhancement module.

In one optional embodiment, the main path module further includes a multiplier and a digital filter. The multiplier is configured to obtain a signal to be modulated according to the digital signal to be processed and the digital gain signal and output the signal to be modulated to the digital filter. The digital filter is configured to filter the signal to be modulated to obtain the digital signal.

In one optional embodiment, the main path module further includes a digital filter. The digital filter is configured to filter the digital signal to be processed and the digital gain signal and obtain the digital signal according to a filtered digital signal to be processed and a filtered digital gain signal.

In one optional embodiment, the dynamic range enhancement module includes a filter unit, an amplitude determination unit, a dynamic power consumption control unit, a decoding unit, a dynamic quantization modulation unit, and a digital gain calculation unit.

The filter unit is configured to filter the digital signal to be processed to obtain a second filtered signal and output the second filtered signal to the amplitude determination unit.

The amplitude determination unit is configured to perform amplitude detection on the second filtered signal according to a predetermined maximum amplitude threshold and a hysteresis amplitude threshold. The amplitude determination unit is configured to output a radix adjustment signal to the dynamic quantization modulation unit according to an amplitude detection result. The amplitude determination unit is further configured to output a polling number to the dynamic power consumption control unit. The polling number represents the number of the DAC elements in the digital-to-analog conversion array that are polled and turned on.

The dynamic power consumption control unit is configured to generate a first control signal and output the first control signal to the dynamic digital-to-analog conversion module according to the polling number.

The decoding unit is configured to convert the digital signal to be processed into a predetermined coded signal according to a predetermined data expansion bit number. The decoding unit is configured to output the predetermined coded signal to the dynamic quantization modulation unit.

The dynamic quantization modulation unit is configured to adjust a current output radix value according to the radix adjustment signal to obtain a target radix value. The dynamic quantization modulation unit is configured to perform dynamic quantization on the predetermined coded signal by the target radix value to obtain a turn-on number of the DAC elements. The dynamic quantization modulation unit is configured to output a second control signal carrying the turn-on number of the DAC elements to the dynamic digital-to-analog conversion module. The dynamic quantization modulation unit is further configured to output the target radix value to the digital gain calculation unit, where the turn-on number is less than the polling number.

The digital gain calculation unit is configured to obtain the digital gain signal according to the data expansion bit number and the target radix value.

In one optional embodiment, when an amplitude of the second filtered signal is less than a threshold difference within a predetermined duration, the amplitude determination unit is configured to output a first adjustment signal to the dynamic quantization modulation unit. The first adjustment signal is configured to instruct the dynamic quantization modulation unit to adjust the current output radix value. The threshold difference is a difference between the predetermined maximum amplitude threshold and the hysteresis amplitude threshold.

When the amplitude of the second filtered signal is greater than a threshold sum within the predetermined duration, the amplitude determination unit is further configured to output a second adjustment signal to the dynamic quantization modulation unit. The second adjustment signal is configured to instruct the dynamic quantization modulation unit to adjust the current output radix value. The threshold sum is a sum of the predetermined maximum amplitude threshold and the hysteresis amplitude threshold.

When the amplitude of the second filtered signal is not less than the threshold difference and not greater than the threshold sum within the predetermined duration, the amplitude determination unit is further configured to output a third adjustment signal to the dynamic quantization modulation unit. The third adjustment signal is configured to instruct the dynamic quantization modulation unit to maintain the current output radix value.

In one optional embodiment, the dynamic range enhancement module further includes a transition amplitude determination unit. When it is detected that an amplitude of a level transition of the digital signal to be processed is greater than a predetermined amplitude threshold, the transition amplitude determination unit is configured to output a reset signal to the amplitude determination unit, so that the amplitude determination unit controls the dynamic quantization modulation unit to reset based on the reset signal. And/or when it is detected that an amplitude of a level transition of the digital signal to be processed is greater than a predetermined amplitude threshold, the transition amplitude determination unit is configured to output the reset signal to the dynamic quantization modulation unit, so that the dynamic quantization modulation unit resets in response to the reset signal.

In one optional embodiment, the dynamic digital-to-analog conversion module includes a dynamic element matching unit.

The dynamic element matching unit is configured to determine a turn-off number of the DAC elements in the digital-to-analog conversion array according to the first control signal. The dynamic element matching unit is further configured to control a corresponding number of DAC elements in the digital-to-analog conversion array to be turned off based on the turn-off number of the DAC elements. The turn-off number of the DAC elements is a difference between a total number of the DAC elements in the digital-to-analog conversion array and the polling number of the DAC elements. The dynamic element matching unit is further configured to dynamically control, according to the second control signal and a dynamic element matching algorithm, enabled DAC elements in the digital-to-analog conversion array to be turned on in a polling manner based on the turn-on number of the DAC elements, so as to selectively connect to the main path module to form the analog feedback signal.

In one optional embodiment, the digital-to-analog conversion array includes at least one of a current source array, a resistor array, and a capacitor array.

In a second aspect, the present disclosure provides a chip. The chip includes a chip body and the analog-to-digital conversion circuit described above.

In a third aspect, the present disclosure provides a recording device. The recording device includes a device body, a microphone disposed on the device body; and the analog-to-digital conversion circuit described above and the chip described above.

The analog-to-digital conversion circuit provided in the present disclosure dynamically quantizes the digital signal to be processed output by the main path module through the dynamic range enhancement module, thereby obtaining the at least one control signal and outputting the at least one control signal to the dynamic digital-to-analog conversion module. In this way, the dynamic digital-to-analog conversion module dynamically controls the opening and closing of each of the DAC elements in the digital-to-analog conversion array according to the at least one control signal, and the dynamic digital-to-analog conversion module outputs the analog feedback signal to the main path module to achieve gain adjustment, thereby eliminating an OPA disposed on a front end for gain, reducing power consumption, and saving costs. Furthermore, power consumption is reduced by dynamically controlling the opening and closing of each of the DAC elements in the digital-to-analog conversion array.

The aspects of the present disclosure will be more clearly understood from the following description of the embodiments.

### BRIEF DESCRIPTION OF DRAWINGS

The drawings are included to provide a further understanding of embodiments of the present disclosure, which form portions of the specification and are used to illustrate implementation manners of the present disclosure and are intended to illustrate operating principles of the present disclosure together with the description. Apparently, the drawings in the following description are merely some of the embodiments of the present disclosure, and those skilled in the art are able to obtain other drawings according to the drawings without contributing any inventive labor.
FIG. 1 is a schematic diagram of a recording device in the related art.
FIG. 2 is a schematic diagram of a DRE module in the related art.
FIG. 3 is a schematic diagram of a structure for adjusting gain within an ADC in the related art.
FIG. 4 is a schematic diagram of an analog-to-digital conversion circuit according to one embodiment of the present disclosure.
FIG. 5 is a schematic diagram of a first embodiment of a main path module according to one embodiment of the present disclosure.
FIG. 6 is a schematic diagram of a first embodiment of a loop filter according to one embodiment of the present disclosure.
FIG. 7 is a schematic diagram of a second embodiment of the loop filter according to one embodiment of the present disclosure.
FIG. 8 is a schematic diagram of a second embodiment of the main path module according to one embodiment of the present disclosure.
FIG. 9 is a schematic diagram of a third embodiment of the main path module according to one embodiment of the present disclosure.

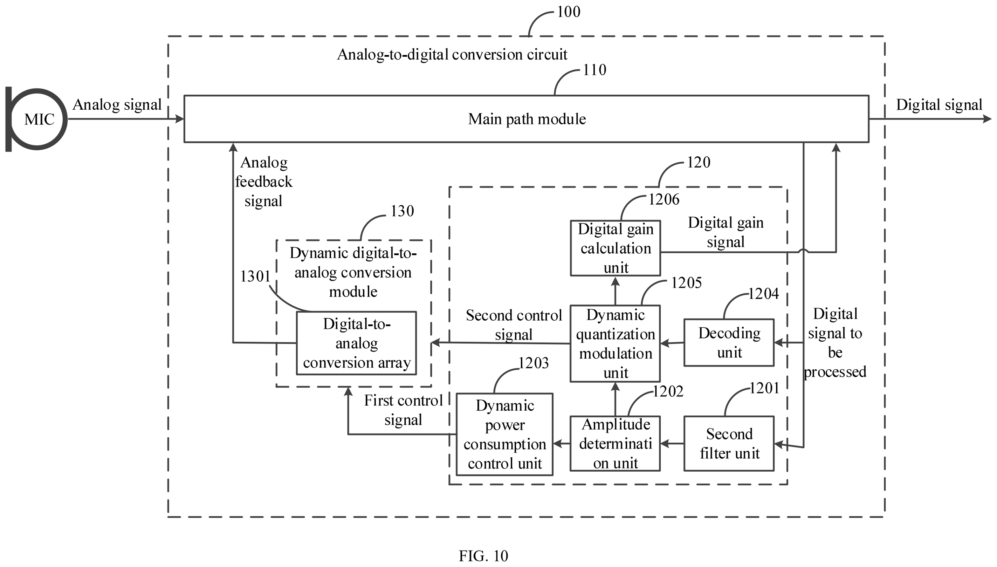

FIG. 10 is a schematic diagram of a first embodiment of a dynamic range enhancement module according to one embodiment of the present disclosure.
FIG. 11 is a schematic diagram of a dynamic quantization modulation unit according to one embodiment of the present disclosure.
FIG. 12 is a spectrum comparison diagram of an audio signal according to one embodiment of the present disclosure.
FIG. 13 is a schematic diagram of a second embodiment of the dynamic range enhancement module according to one embodiment of the present disclosure.
FIG. 14 is a schematic diagram of a dynamic digital-to-analog conversion module according to one embodiment of the present disclosure.
FIG. 15 is a schematic diagram of an application scenario of the analog-to-digital conversion circuit according to one embodiment of the present disclosure.

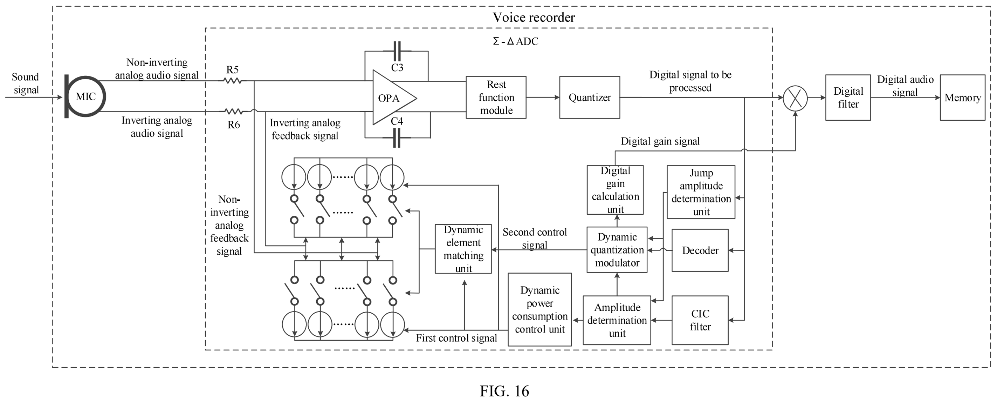

FIG. 16 is a schematic diagram of another application scenario of the analog-to-digital conversion circuit according to one embodiment of the present disclosure.

### DETAILED DESCRIPTION

Embodiments of the present disclosure are described in detail below. Examples of the embodiments are shown in the accompanying drawings, in which the same or similar reference numerals indicate the same or similar elements or elements with the same or similar functions. The embodiments described below with reference to the drawings are exemplary, and are intended to explain the present disclosure, but should not be regarded as a limitation to the present disclosure.

In order to make those skilled in the art better understand technical solutions of the present disclosure, the technical solutions in the embodiments of the present disclosure are clearly and completely described below in conjunction with the accompanying drawings in the embodiments of the present disclosure. Obviously, the described embodiments are only a part of the embodiments of the present disclosure, rather than all of the embodiments. Based on the embodiments of the present disclosure, all other embodiments obtained by those of ordinary skill in the art without creative work shall fall within the protection scope of the present disclosure.

It should be noted that, in the present disclosure, relational terms, such as "first" and "second", are only used to distinguish one feature or operation from another feature or operation, and do not necessarily require or imply any actual relationship or sequence exists between these features or operations.

Moreover, terms "include", "include" or any other variation thereof are intended to encompass non-exclusive inclusion, such that a process, method, article or device not only includes elements explicitly listed, but also includes elements not explicitly listed or other elements inherent to such a process, method, article or device. Without further limitation, elements defined by the statement "including a ..." do not preclude the existence of additional identical elements in the process, method, article, or device including the elements.

In the description of the embodiments of the present disclosure, terms such as "example" or "for example" are configured to represent examples, descriptions, or descriptions. Any embodiment or design scheme described as "example" or "for example" in the embodiments of the present disclosure is not to be construed as being more preferred or having more advantages than another embodiment or design scheme. The use of words such as "example" or "for example" is intended to present relative concepts in a clear manner.

In addition, "a plurality of" in the embodiments of the present disclosure refers to two or more. In view of this, "a plurality of" may also be understood as "at least two" in the embodiments of the present disclosure. "At least one" may be understood as one or more, such as one, two, or more. For example, the term "at least one of" means that one, two, or more elements are included. For example, the phase "at least one of A, B, and C" means that there may be A, B, C, A and B, A and C, B and C, or A and B and C.

It should be understood in the description of the present disclosure that the term "and/or" depicts a relationship between associated objects and there are three relationships thereon. For example, A and/or B may indicate A exists alone, A and B exist at the same time, and B exists alone. The character "/" generally indicates that the associated object is alternative. The terms "first", "second", "third", etc. in the present disclosure are used only to distinguish similar objects and do not imply a specific ordering of objects.

It should be noted that in the embodiments of the present disclosure, "connection" can be understood as electrical connection, and the connection between two electrical components can be a direct or indirect connection between the two electrical components. For example, the connection between A and B can be either a direct connection between A and B or an indirect connection between A and B through one or more other electrical components.

Before introducing the analog-to-digital conversion circuit, chip and recording device of the present disclosure, the related art of the embodiments of the present disclosure is first introduced.

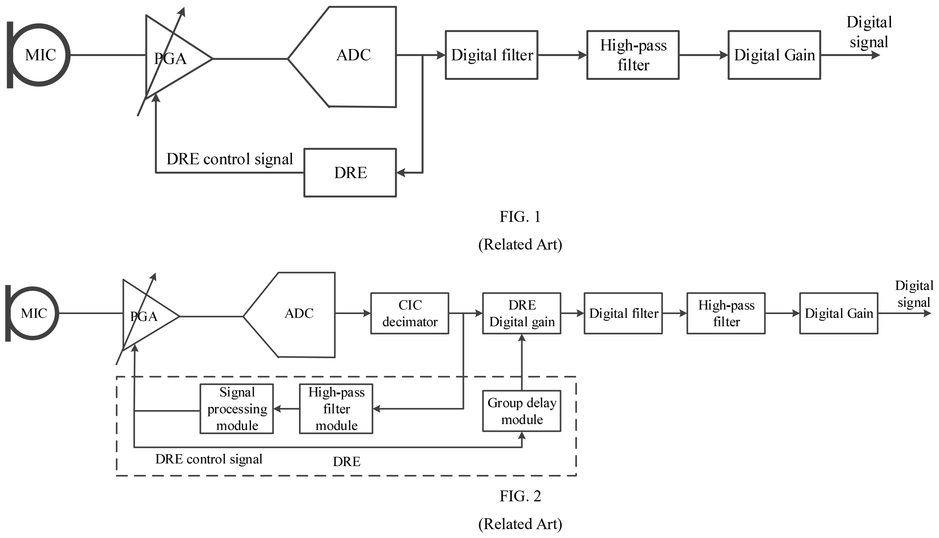

FIG. 1 is a schematic diagram of a recording device in the related art. As shown in FIG. 1, a microphone MIC receives a sound signal and generates a weak electrical signal. The weak electrical signal is then amplified by a programmable gain amplifier (PGA) and output to an analog-to-digital converter (ADC). The ADC converts an amplified electrical signal into a digital signal. After digital processing through a digital filter, a high-pass filter, and a digital gain module, the digital signal is converted into a final digital signal for outputting. It is understood that the final digital signal is stored on disk or input into another module capable of processing digital signals for subsequent processing.

In an entire signal processing path shown in FIG. 1, the PGA and ADC are primary sources of noise, impacting recording performance of the entire signal processing path. Generally speaking, a low-noise PGA is easier to produce than a low-noise ADC.

Therefore, when ADC performance is lower than PGA performance, e.g., when a noise of the MIC is 4uV and a signal noise ratio (SNR) of the MIC is 70dB, a noise of the PGA is 2uV, and a noise of the ADC is 10uV.

When a gain of the PGA is configured to 0dB gain and a gain of a digital module is configured to 0dB, a gain of the entire signal processing path is 0dB. A final SNR of the entire signal processing path is 61.3dB, a performance loss is 8.7dB.

When the gain of the PGA is configured to26dB and the gain of the digital module is reduced by 26dB, the gain of the entire signal processing path remains at 0dB, the final SNR of the entire signal processing path is 69dB, and the performance loss is 1dB.

It indicates that, when the gain of the entire signal processing path remains 0dB, and when a small signal is input, using the PGA having the gain of 0dB for recording may result in a greater performance loss than using the PGA having the gain of 26dB gain for recording, resulting in poorer recording quality.

Since an input signal (i.e., the weak electrical signal) of the MIC is generally a small signal. In the related art, when the input signal of the MIC is a small signal, the PGA having a larger gain is configured to improve the recording performance; and when the input signal of the MIC is a large signal, the PGA having a smaller gain is configured to avoid output swing overflow and clipping.

As shown in FIG. 2, dynamically adjusting the gain of the PGA based on the input signal and using digital gain to inversely compensate for the gain while maintaining the gain of the entire signal processing path constant improves small-signal performance of the ADC and thus improves a dynamic range. Therefore, as shown in FIGS. 1 and 2, when ADC performance is not very high, dynamically adjusting the gain of the PGA and inversely adjusting the digital gain by an output control signal of a dynamic range enhancer (DRE) improves the performance of the entire signal processing path, leading to better recording performance. However, the method significantly increases a power consumption and the area of the entire signal processing path, which is detrimental to both cost and power consumption.

To reduce costs and power consumption, in the related art, gain adjustment is further performed inside the ADC. For example, the gain adjustment is achieved by adjusting a current or a resistance of a digital-to-analog conversion module disposed inside the ADC. However, the method significantly alters a transfer function of the overall path of the ADC, potentially posing a risk to stability. Furthermore, when adjusting the current or the resistance, a change in the current or the resistance takes time to settle, and a feedback signal during a settling process may have significant deviations, potentially causing the ADC to output erroneous data.

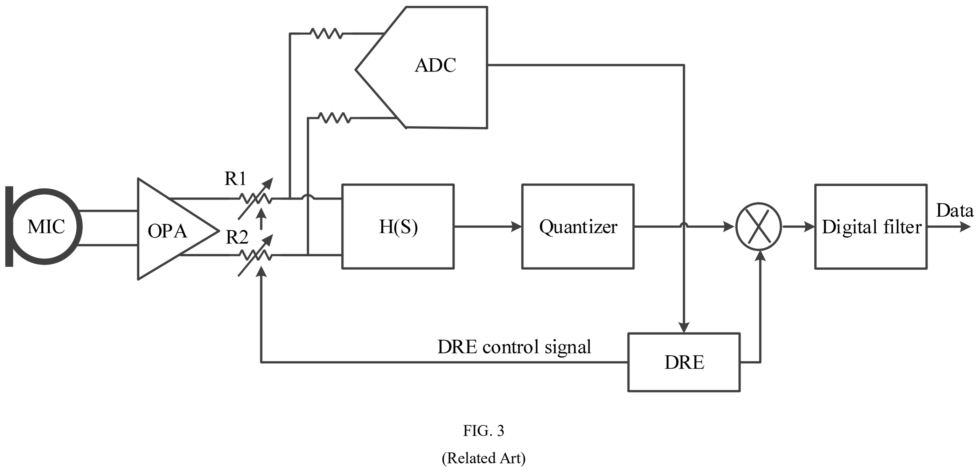

To avoid the problem, as shown in FIG. 3, in the related art, the gain adjustment inside the ADC is achieved by adjusting an input resistor connected to an input port of the ADC. However, by adopting the method, an operational amplifier (OPA) needs to be connected between the microphone and the ADC. The OPA provides a low-impedance output resistance path and isolates an effect of equivalent output resistance of the microphone on the gain. Without the OPA with a fixed gain, an input resistance of the ADC constantly changes, causing a signal gain of the microphone to deviate, making it difficult to achieve a required matching of digital and analog gain in the DRE. Therefore, even though the method does not require the PGA, the introduction of the OPA still increases the power consumption.

In view of problems in the related art, the present disclosure provides an analog-to-digital conversion circuit, a chip, and a recording device to solve the problems.

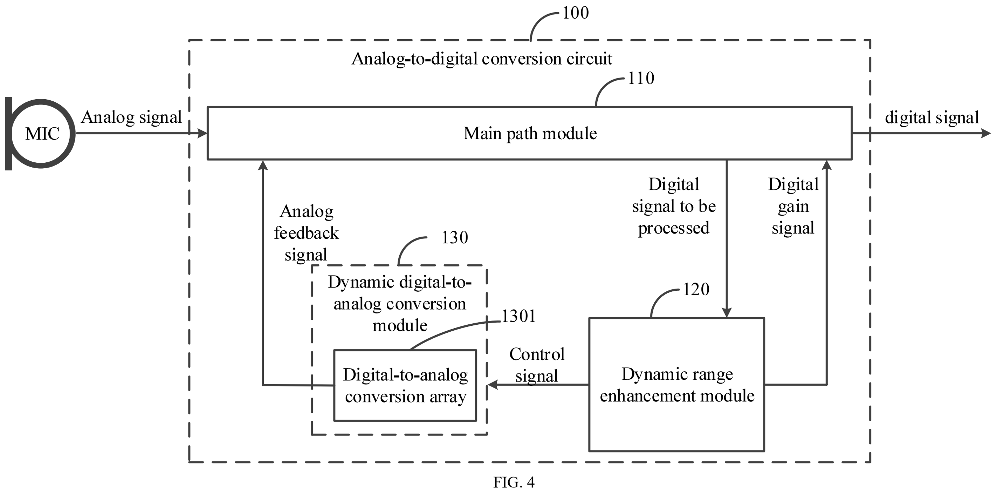

In a first aspect, the present disclosure provides an analog-to-digital conversion circuit. FIG. 4 is a schematic diagram of the analog-to-digital conversion circuit according to one embodiment of the present disclosure. As shown in FIG. 4, the analog-to-digital conversion circuit 100 includes a main path module 110, a dynamic range enhancement module 120, and a dynamic digital-to-analog conversion module 130. The dynamic digital-to-analog conversion module 130 includes a digital-to-analog conversion array 1301.

The main path module 110 is configured to convert an analog signal and an analog feedback signal from the dynamic digital-to-analog conversion module 130 into a digital signal to be processed. The main path module 110 is configured to output the digital signal to be processed to the dynamic range enhancement module 120. The main path module 110 is further configured to obtain a digital signal output according to the digital signal to be processed and a digital gain signal from the dynamic range enhancement module 120.

The dynamic range enhancement module 120 is configured to perform dynamic quantization processing on the digital signal to be processed to obtain a control signal. The dynamic range enhancement module 120 is configured to output the control signal to the dynamic digital-to-analog conversion module 130. The dynamic range enhancement module 120 is further configured to generate the digital gain signal and output the digital gain signal to the main path module 110.

The dynamic digital-to-analog conversion module 130 is configured to dynamically control on and off of each of the digital-to-analog converter (DAC) elements in the digital-to-analog conversion array 1301 according to the control signal and output the analog feedback signal to the main path module 110.

In the embodiments of the present disclosure, the analog signal is a signal from a sound sampling device such as a microphone, a signal from an internal memory, a signal from an external storage module, or a signal from a signal processing module.

As shown in FIG. 4, when the analog-to-digital conversion circuit 100 is applied in a recording device, the recording device includes a microphone MIC for collecting sound signals. Each of collected sound signals is converted by the microphone MIC into an analog signal and then output to the main path module 110.

In other embodiments, the analog signal is sent from a memory of the recording device to the main path module 110 in response to a trigger signal from a central processing unit (CPU) or a microcontroller unit (MCU).

In some other embodiments, the analog signal may be a signal output to the main path module 110 by the external memory or the signal processing module connected to the recording device.

The analog signal in the embodiments of the present disclosure may be a single-ended signal, a differential signal, a signal with or without DC isolation, etc. It is understood that the analog signal is determined based on an actual application scenario and is not limited thereto.

In the embodiments of the present disclosure, the dynamic digital-to-analog conversion module 130 is configured to output the analog feedback signal to an input end of the main path module 110. It is understood that the main path module 110 may use the analog feedback signal to perform analog gain adjustment on the analog signal.

After performing analog gain adjustment on the analog signal, the main path module 110 further performs corresponding processing on an adjusted analog signal, such as integration, filtering, quantization, etc., to generate the digital signal to be processed. Then the digital signal to be processed is output to the dynamic range enhancement module 120.

In the embodiment of the present disclosure, the dynamic range enhancement module 120 dynamically quantizes the digital signal to be processed. Based on parameters configured for dynamic quantization, an analog gain is determined, and the digital gain is inversely determined based on the analog gain. The dynamic range enhancement module 120 then outputs the control signal to the dynamic digital-to-analog conversion module 130 and the digital gain signal to the main path module 110.

After receiving the control signal, the dynamic digital-to-analog conversion module 130 dynamically controls on and off of each of the digital-to-analog converter (DAC) elements in the digital-to-analog conversion array 1301 according to the control signal, thereby generating the analog feedback signal for output to the main path module 110.

It is understood that each of the DAC elements is a small unit in the digital-to-analog conversion array 1301. In the embodiment, the digital-to-analog conversion array 1301 includes at least one of a current source array, a resistor array, and a capacitor array.

For example, when the digital-to-analog conversion array 1301 is the current source array, each of the DAC elements is a current source in the current source array. When the digital-to-analog conversion array 1301 is the resistor array, each of the DAC elements is a resistor in the resistor array. When the digital-to-analog conversion array 1301 is the capacitor array, each of the DAC elements is a capacitor in the capacitor array. When the digital-to-analog conversion array 1301 is a combination of the current source array and the resistor array, the DAC elements are current sources in the current source array and resistors in the resistor array. The digital-to-analog conversion array 1301 is selected according to the actual application scenario and is not specifically limited thereto.

In the embodiment of the present disclosure, the digital gain is reversely determined by the dynamic range enhancement module 120 based on the analog gain. Therefore, after receiving the digital gain signal, the main path module 110 performs reverse digital gain adjustment on the digital signal to be processed based on the digital gain signal, so that an overall path gain of the analog-to-digital conversion circuit 100 remains unchanged, thereby improving a dynamic range of the analog-to-digital conversion circuit 100.

The analog-to-digital conversion circuit 100 provided in the present disclosure dynamically quantizes the digital signal to be processed output by the main path module 110 through the dynamic range enhancement module 120, thereby obtaining the control signal and outputting the control signal to the dynamic digital-to-analog conversion module 130. In this way, the dynamic digital-to-analog conversion module 130 dynamically controls the opening and closing of each of the DAC elements in the digital-to-analog conversion array 1301 according to the control signal, and the dynamic digital-to-analog conversion module 130 outputs the analog feedback signal to the main path module 110 to achieve gain adjustment, thereby eliminating an OPA disposed on a front end for gain, reducing power consumption, and saving costs. Furthermore, power consumption is reduced by dynamically controlling the opening and closing of each of the DAC elements in the digital-to-analog conversion array 1301.

Furthermore, compared to the related art where the DRE is independent from the ADC, the analog-to-digital conversion circuit 100 of the present disclosure includes the dynamic range enhancement module 120. In other words, the DRE is fully implemented within the analog-to-digital conversion circuit 100, which reduces a latency of a DRE detection path and ensures faster response. Furthermore, by dynamically controlling the on and off of each of the DAC elements in the digital-to-analog conversion array 1301, the gain of the analog signal is not affected. Analog gain adjustment is primarily achieved through digital configuration parameters within the dynamic range enhancement module 120, making matching of the analog gain and the digital gain easier.

Next, various unit/modules shown in FIG. 4 and possible implementations in practical applications are described in detail.

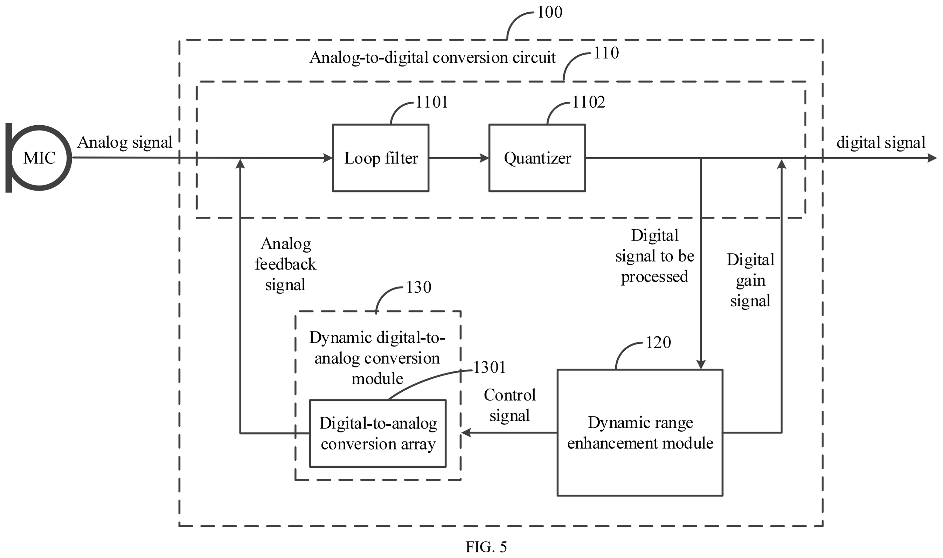

As shown in FIG. 5, in some embodiments, the main path module 110 includes a loop filter 1101 and a quantizer 1102.

The loop filter 1101 is configured to perform integral filtering processing on the analog signal and the analog feedback signal to obtain a first filtered signal and output the first filtered signal to the quantizer 1102.

The quantizer 1102 is configured to perform quantization processing on the first filtered signal to obtain the digital signal to be processed and output the digital signal to the dynamic range enhancement module 120.

In the embodiments of the present disclosure, the loop filter 1101 may be any loop filter in the related art, including but not limited to an active loop filter or a passive loop filter. The quantizer 1102 may be any quantizer in the related art.

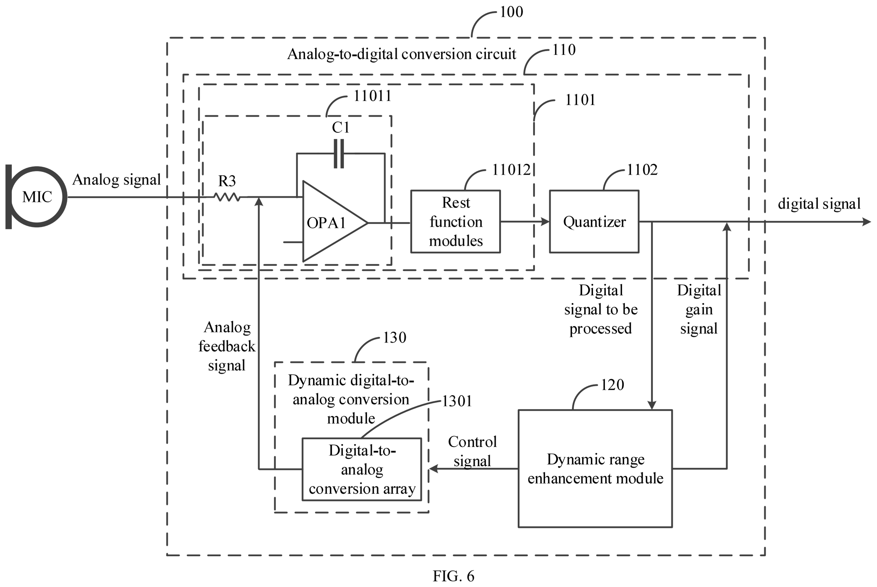

As shown in FIG. 6, in one embodiment, the loop filter 1101 may include an integrator 11011 and rest functional modules 11012 (rest functional modules 11012 refer only to other circuits within the loop filter 1101). The integrator 11011 includes a first input resistor R3, a first capacitor C1, and a first-stage operational amplifier OPA1.

Specifically, the first input resistor R3 is connected to a non-inverting input end of the first-stage operational amplifier OPA1. The first capacitor C1 is connected between the non-inverting input end and an output end of the first-stage operational amplifier OPA1. The output end of the first-stage operational amplifier OPA1 is connected to an input end of the rest functional modules 11012. An output end of the rest functional modules 11012 is connected to an input end of the quantizer 1102. Thus, an integration and filtering processing of the analog signal and the analog feedback signal is achieved through the integrator 11011 and the rest functional modules 11012.

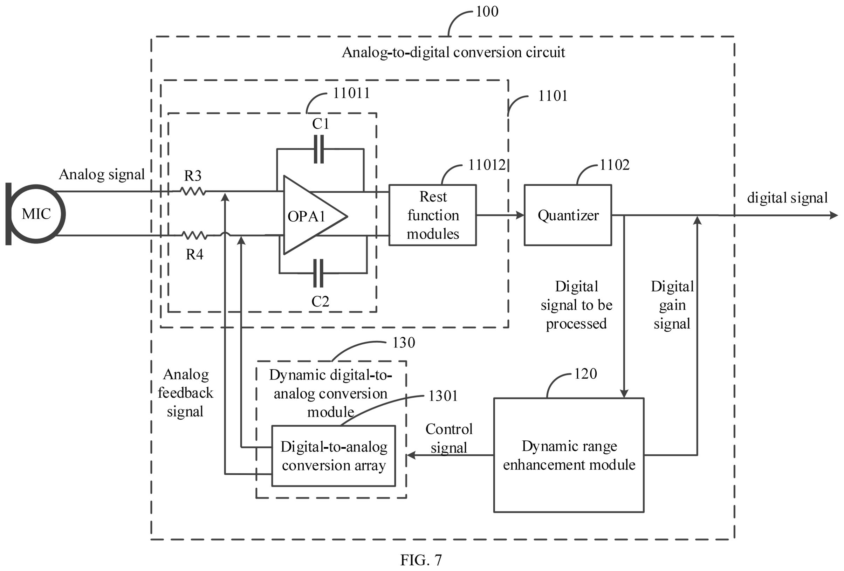

It is understood that a structure shown in FIG. 6 corresponds to an application scenario where the analog signal is the single-ended signal. When the analog signal is the differential signal, then as shown in FIG. 7, the integrator 11011 includes a second input resistor R4 and a second capacitor C2. In this case, the first capacitor C1 is connected between the non-inverting input end and a first output end of the first-stage operational amplifier OPA1, the second input resistor R4 is connected to an inverting input end of the first-stage operational amplifier OPA1, and the second capacitor C2 is connected between the inverting input end and a second output end of the first-stage operational amplifier OPA1. The analog signal (which is the differential signal) and the analog feedback signal are respectively input to the integrator 11011. The integrator 11011 and rest functional modules 11012 perform integration and filtering on the analog signal and the analog feedback signal.

In the embodiment of the present disclosure, after quantization by the quantizer 1102, the first filtered signal generates the digital signal to be processed of M bits, and the digital signal to be processed is output to the dynamic range enhancement module 120.

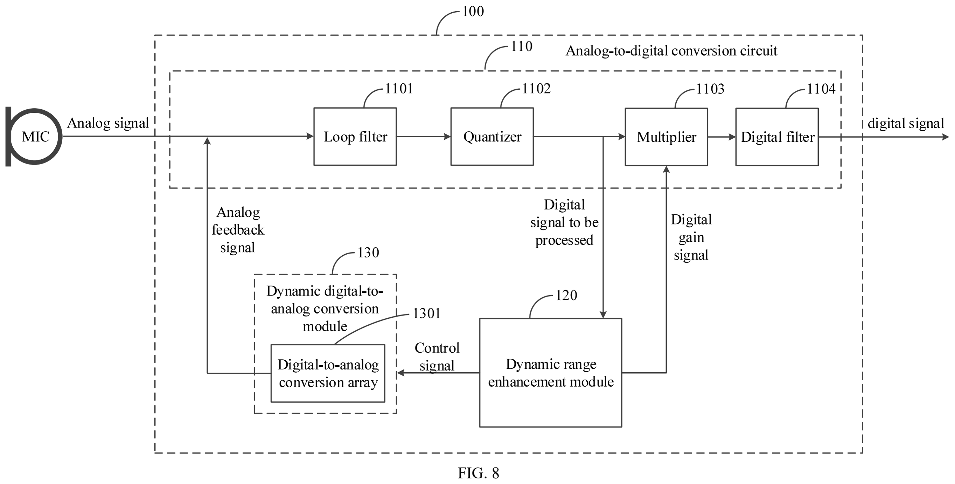

As shown in FIG. 8, in some embodiments, the main path module 110 further includes a multiplier 1103 and a digital filter 1104.

The multiplier 1103 is configured to obtain a signal to be modulated according to the digital signal to be processed and the digital gain signal and output the signal to be modulated to the digital filter 1104. The digital filter 1104 is configured to filter the signal to be modulated to obtain the digital signal.

In the embodiment, the multiplier 1103 may be any multiplier in the related art, and the digital filter 1104 may be any filter for processing digital signals. As shown in FIG.8. In the embodiment, the digital gain adjustment of the digital signal to be processed is performed before sending to the digital filter 1104.

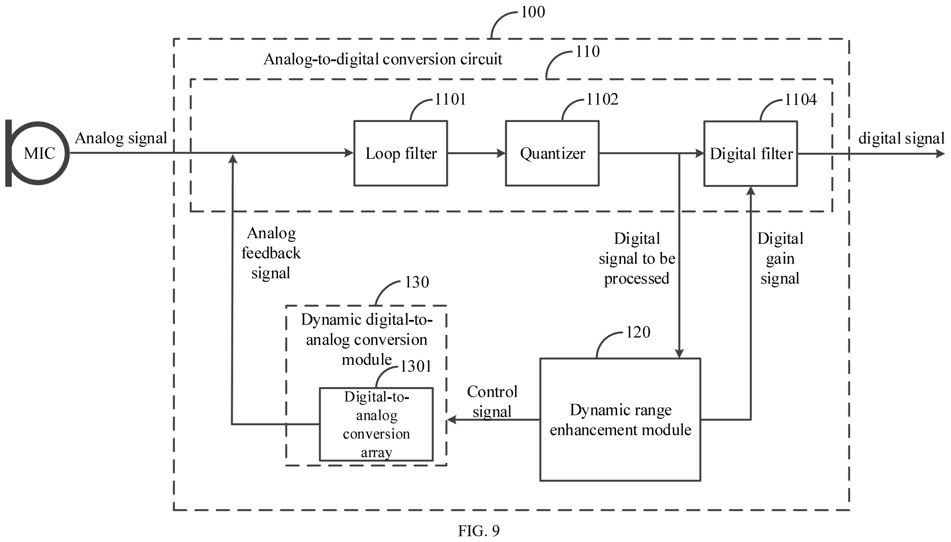

As shown in FIG. 9, in an alternate embodiment, the digital gain adjustment of the digital signal to be processed is performed in the digital filter 1104. In this case, the main path module 110 further includes the digital filter 1104. The digital filter 1104 is configured to filter the digital signal to be processed and the digital gain signal and obtain the digital signal according to a filtered digital signal to be processed and a filtered digital gain signal. A digital signal is obtained according to a filtered digital signal to be processed and a filtered digital gain signal.

In some embodiments, the dynamic range enhancement module 120 includes a filter unit 1201, an amplitude determination unit 1202, a dynamic power consumption control unit 1203, a decoding unit 1204, a dynamic quantization modulation unit 1205, and a digital gain calculation unit 1206.

The filter unit 1201 is configured to filter the digital signal to be processed to obtain a second filtered signal and output the second filtered signal to the amplitude determination unit 1202.

In the embodiment of the present disclosure, the filter unit 1201 may be any filter in the related art. In one specific implementation, the filter unit 1201 is a cascaded integrator-comb decimator (CIC) filter. The CIC filter is configured to filter out high-frequency noise energy from the digital signal to be processed.

In the embodiment, the number of stages of the CIC filter and a length of the CIC filter are adjusted by configuring a register to balance a delay effect and a filtering effect of the CIC filter.

For example, when the number of stages of the CIC filter and the length of the CIC filter are small, the CIC filter has a short delay and a fast response speed, but the CIC filter may have a poor filtering effect, which leads to a high jitter in the output second filtered signal. On the other hand, when the number of stages of the CIC filter and a length of the CIC filter are too large, the CIC filter has a good filtering effect and outputs the second filtered signal with lower jitter, but the CIC filter may have a high delay and a slow response speed. Therefore, the number of the stages and the length of the CIC filter is determined based on the actual application scenario.

In the embodiment of the present disclosure, the filter unit 1201 is able to filter the digital signal to be processed (which is of M bits and output by the quantizer 1102, also defined as a M-bit digital signal to be processed) to obtain the second filtered signal from which the high-frequency noise is filtered out. The second filtered signal is output to the amplitude determination unit 1202. Specifically, M may be any value such as 2, 3, 4, 5, etc.

The amplitude determination unit 1202 is configured to perform amplitude detection on the second filtered signal according to a predetermined maximum amplitude threshold and a hysteresis amplitude threshold. The amplitude determination unit 1202 is configured to output a radix adjustment signal to the dynamic quantization modulation unit 1205 according to an amplitude detection result. The amplitude determination unit 1202 is further configured to output a polling number to the dynamic power consumption control unit 1203. The polling number represents the number of the DAC elements in the digital-to-analog conversion array 1301 that are polled and turned on. It is understood that the polling number is not greater than a total number of the DAC elements in the digital-to-analog conversion array 1301.

In the embodiment, when an amplitude of the second filtered signal is less than a threshold difference within a predetermined duration, the amplitude determination unit 1202 is configured to output a first adjustment signal to the dynamic quantization modulation unit 1205. The first adjustment signal is configured to instruct the dynamic quantization modulation unit 1205 to adjust the current output radix value. The threshold difference is a difference between the predetermined maximum amplitude threshold and the hysteresis amplitude threshold.

When the amplitude of the second filtered signal is greater than a threshold sum within the predetermined duration, the amplitude determination unit 1202 is further configured to output a second adjustment signal to the dynamic quantization modulation unit 1205. The second adjustment signal is configured to instruct the dynamic quantization modulation unit 1205 to adjust the current output radix value. The threshold sum is a sum of the predetermined maximum amplitude threshold and the hysteresis amplitude threshold.

When the amplitude of the second filtered signal is not less than the threshold difference and not greater than the threshold sum within the predetermined duration, the amplitude determination unit 1202 is further configured to output a third adjustment signal to the dynamic quantization modulation unit 1205. The third adjustment signal is configured to instruct the dynamic quantization modulation unit 1205 to maintain the current output radix value.

In the embodiment of the present disclosure, the maximum amplitude threshold is determined based on past experience or experiments combined with actual application scenarios. For example, the maximum amplitude threshold is any value between -18dBFS and -6dBFS. The hysteresis amplitude threshold is any value between 0dBFS and 5dBFS. The predetermined duration is configured via the register. For example, the predetermined duration is any value between 10µs and 2s.

For example, when the current output radix value is 4, the predetermined duration is 1second (s), the maximum amplitude threshold is -15dBFS, and the hysteresis amplitude threshold is 5dBFS, then the threshold difference is -20dBFS, and the threshold sum is -10dBFS.

When the amplitude of the second filtered signal remains less than -20dBFS within 1s, the amplitude determination unit 1202 outputs the first adjustment signal to the dynamic quantization modulation unit 1205 to instruct the dynamic quantization modulation unit 1205 to increase the current output radix value of 4 to 5 (assuming an adjustment step size is 1).

When the amplitude of the second filtered signal remains greater than -10 dBFS for 1 second, the amplitude determination unit 1202 outputs the second adjustment signal to the dynamic quantization modulation unit 1205 to instruct the dynamic quantization modulation unit 1205 to reduce the current output radix value of 4 to 3 (assuming the adjustment step size is 1).

When the amplitude of the second filtered signal remains between -20 dBFS and -10 dBFS, the amplitude determination unit 1202 outputs the third adjustment signal to the dynamic quantization modulation unit 1205 to instruct the dynamic quantization modulation unit 1205 to maintain the current output radix value of 4.

To achieve rapid response when the amplitude of the second filtered signal increases and avoid distortion caused by excessive amplitude due to untimely output value adjustment, in one embodiment, a value of the predetermined duration for determining when the amplitude of the second filtered signal increases is different from a value of the predetermined duration for determining when the amplitude of the second filtered signal decreases. For example, the predetermined duration for determining when the amplitude of the second filtered signal increases is 100 µs, and the predetermined duration for determining when the amplitude of the second filtered signal decreases is 1 second.

In this case, when the amplitude of the second filtered signal remains less than -20 dBFS within 1 s, the amplitude determination unit 1202 outputs the first adjustment signal to the dynamic quantization modulation unit 1205 to instruct the dynamic quantization modulation unit 1205 to increase the current output radix value of 4 to 5 (assuming the adjustment step size is 1).

When the amplitude of the second filtered signal remains greater than -10 dBFS within 100 µs, the amplitude determination unit 1202 outputs the second adjustment signal to the dynamic quantization modulation unit 1205 to instruct the dynamic quantization modulation unit 1205 to decrease the current output radix value of 4 to 3 (assuming the adjustment step size is 1), thereby achieving rapid response.

When the amplitude of the second filtered signal always remains between -20 dbFS and -10 dbFS, the amplitude determination unit 1202 outputs the third adjustment signal to the dynamic quantization modulation unit 1205 to instruct the dynamic quantization modulation unit 1205 to maintain the current output radix value of 4 unchanged.

In the embodiment, the amplitude determination unit 1202 is further configured to determine the polling number based on the amplitude and variation of the second filtered signal and output the polling number to the dynamic power consumption control unit 1203.

For example, the polling number is divided into four segments based on the total number of the DAC elements in the digital-to-analog conversion array 1301. The four segments are respectively 1/4, 1/2, 3/4, and all of the total number of the DAC elements. Accordingly, the amplitude of the second filtered signal is compared with amplitudes corresponding to the DAC elements to match different polling numbers.

For example, when the amplitude of the second filtered signal is less than 1/8 of a total amplitude of the DAC elements when all of the DAC elements are on, the polling number is 1/4 of the total number of the DAC elements.

When the amplitude of the second filtered signal is less than 3/8 of the total amplitude of the DAC elements but not less than 1/8 of the total amplitude of the DAC elements, the polling number is 1/2 of the total number of the DAC elements.

When the amplitude of the second filtered signal is less than 5/8 of the total amplitude of the DAC elements but not less than 3/8 of the total amplitude of the DAC elements, the polling number is 3/4 of the total number of the DAC elements.

When the amplitude of the second filtered signal is not less than 5/8 of the total amplitude of the DAC elements, the polling number is the total number of the DAC elements.

In the embodiment, when the amplitude of the second filtered signal changes from low to high and exceeds an upper threshold, the polling number output by the amplitude determination unit 1202 immediately increases. When the amplitude of the second filtered signal changes from high to low and crosses a lower threshold, the amplitude determination unit 1202 outputs a smaller polling number to the dynamic power consumption control unit 1203 after monitoring that the amplitude of the second filtered signal is continuously less than the lower threshold within the predetermined duration, thereby avoiding the adverse effects caused by short-term signal fluctuations.

In the embodiment of the present disclosure, after receiving the polling number from the amplitude determination unit 1202, the dynamic power consumption control unit 1203 is configured to generate a first control signal and output the first control signal to the dynamic digital-to-analog conversion module 130, so as to control an operation of the digital-to-analog conversion array 1301 in the dynamic digital-to-analog conversion module 130.

In the embodiment of the present disclosure, the decoding unit 1204 is configured to convert the digital signal to be processed into a predetermined coded signal according to a predetermined data expansion bit number. The decoding unit 1204 is configured to output the predetermined coded signal to the dynamic quantization modulation unit 1205.

The decoding unit 1204 may be any decoder in the related art. The predetermined data expansion bit number may be any integer value, such as 0, 1, 2, or 3, which is determined based on the actual application scenario.

Assuming the predetermined data expansion bit number is N, the decoding unit 1204 is configured to expand a bit width of the M-bit digital signal to be processed output by the quantizer 1102 based on the predetermined data expansion bit number N, so that the data output by the decoding unit 1204 has a bit width of (M+N) bits. In the embodiment, N-bit expansion data is achieved by adding zero, a pseudo-random noise, or a random noise generated by an analog circuit.

For example, when M is 5, the quantizer 1102 outputs a 5-bit digital signal to be processed. Assuming a data size of the digital signal to be processed is 15 (binary representation 01111). When N is set to 4 and a data size of added noise data is 5 (binary representation 0101), the expanded output of the decoding unit 1204, i.e., the present encoding signal is 9 bits, and a data size of the present encoding signal is 245 (binary representation 011110101). It is understood that when N is set to 0, it means that the digital signal to be processed is not expanded.

In the embodiment, the dynamic quantization modulation unit 1205 is configured to adjust a current output radix value according to the radix adjustment signal to obtain a target radix value. The dynamic quantization modulation unit 1205 is configured to perform dynamic quantization on the predetermined coded signal by the target radix value to obtain a turn-on number of the DAC elements. The dynamic quantization modulation unit 1205 is configured to output a second control signal carrying the turn-on number of the DAC elements to the dynamic digital-to-analog conversion module 130. The dynamic quantization modulation unit 1205 is further configured to output the target radix value to the digital gain calculation unit 1206, where the turn-on number is less than the polling number.

In the embodiment, the dynamic quantization modulation unit 1205 is configured to intercept and perform interception error modulation on the predetermined coded signal from the decoding unit 1204.

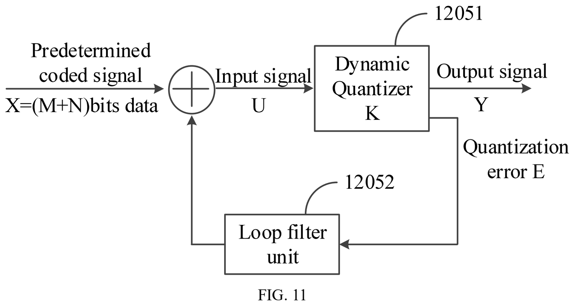

As shown in FIG. 11, the dynamic quantization modulation unit 1205 includes a dynamic quantizer 12051 and a loop filter unit 12052. The predetermined coded signal X is added to a signal passing through the loop filter unit 12052 to form an input signal U. The input signal U is input to the dynamic quantizer 12051. The dynamic quantizer 12051 truncates high-order bits of the input signal U based on the current output radix value K to generate an output signal Y. The output signal Y is the second control signal and is then transmitted to the dynamic digital-to-analog conversion module 130. The output signal Y is obtained by dividing the input signal U by the current output radix value K, rounded to the integer. A difference between an input and an output of the dynamic quantizer 12051 is a quantization error E, which is transmitted to the loop filter unit 12052 for feedback.

In the embodiment, a parameter K is configured for the dynamic quantizer 12051 as the output radix value for quantization. K may be any value not less than 1, such as 2, 3.5, or 6.

The radix adjustment signal output by the amplitude determination unit 1202 is transmitted to the dynamic quantizer 12051. When the radix adjustment signal is the first adjustment signal, the current output radix value K is increased based on a predetermined adjustment step size (i.e., the adjustment step size mentioned above) to obtain the target radix value. When the radix adjustment signal is the second adjustment signal, the current output radix value K is decreased based on the predetermined adjustment step size to obtain the target radix value. When the radix adjustment signal is the third adjustment signal, the current output radix value K remains unchanged, i.e., the target radix value K is obtained. In the embodiment, the predetermined adjustment step size is configured and adjusted via the register and is a positive decimal or a positive integer, such as 1, 1.5, 2, etc.

The dynamic quantizer 12051 re-quantizes and modulates the data of (M+N) bits (i.e, the predetermined coded signal, also defined as an (M+N)-bit predetermined coded signal) sent from the decoding unit 1204 based on an adjusted current output radix value K (i.e., the target radix value K). After changing an output bit width of the data, the second control signal carrying the turn-on number is generated and output to the dynamic digital-to-analog conversion module 130.

The output signal Y of the dynamic quantizer 12051 is fix(U/K), where fix represents rounding to zero. For example, fix(5.4) = 5, fix(-3.1) = -3. The quantization error E = U - Y*K, and the input signal U = X + E*((1-z^{^-1})^{^n}+1).

In the embodiment, an absolute value of Y output by the dynamic quantizer 12051 is the turn-on number of the DAC elements, which represents the number of DAC elements in the digital-to-analog conversion array 1301 that need to be turned on. Compared to the (M+N)-bit predetermined coded signal output by decoding unit 1204, since the target radix value K is any value not less than 1, the bit width of the data output by dynamic quantizer 12051 is reduced. That is, the number of the DAC elements needed to be turned on is reduced compared to the number of the DAC elements that originally need to be turned on. That is, the dynamic quantizer 12051 improves a gain of K.

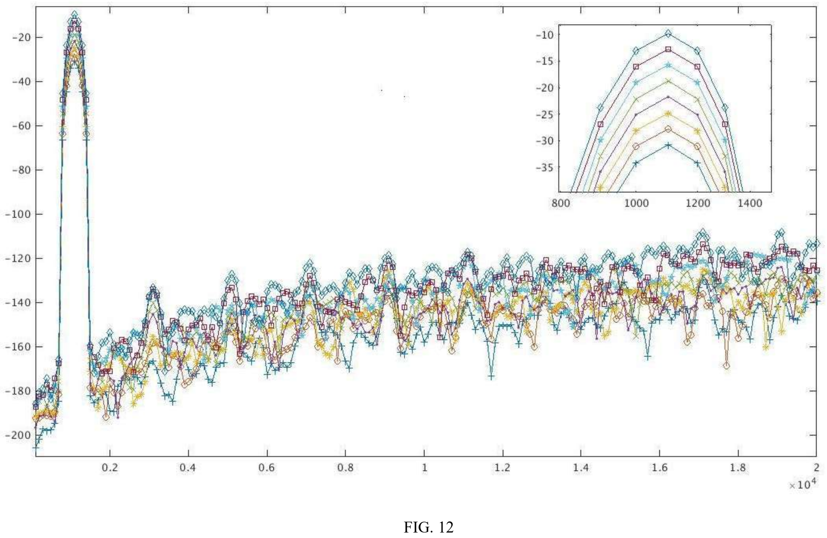

Please refer to a spectrum diagram shown in FIG. 12, which shows amplitude variations of the digital signal for different values of the target radix value K. As can be seen from an enlarged diagram in an upper right corner of FIG. 12, as the target radix value K increases, the gain of the digital signal gradually changes from -32dB to -12dB.

It should be understood that the example of the dynamic quantization modulation unit 1205 in the embodiment is not the only implementation of the dynamic quantization modulation unit 1205. All methods that achieve dynamic gain adjustment by re-adjusting the bit width through dynamic quantization are within the protection scope of the present disclosure.

In the embodiment, the digital gain calculation unit 1206 is configured to obtain the digital gain signal according to the target radix value from the dynamic quantization modulation unit 1205.

In the embodiment, the data expansion bit number N in the decoding unit 1204 enables the dynamic quantization modulation unit 1205 to perform more detailed quantization calculations. However, in actual applications, the data expansion bit number N is commonly set to a fixed value in advance. It is understood that an analog output gain is K. The analog output gain is configured by adjusting the target radix value K. Correspondingly, the digital gain is calculated by dividing 1 by the target radix value K, i.e., 1/K. In this way, the matching between the analog gain and the digital gain is achieved, ensuring that the path gain remains unchanged.

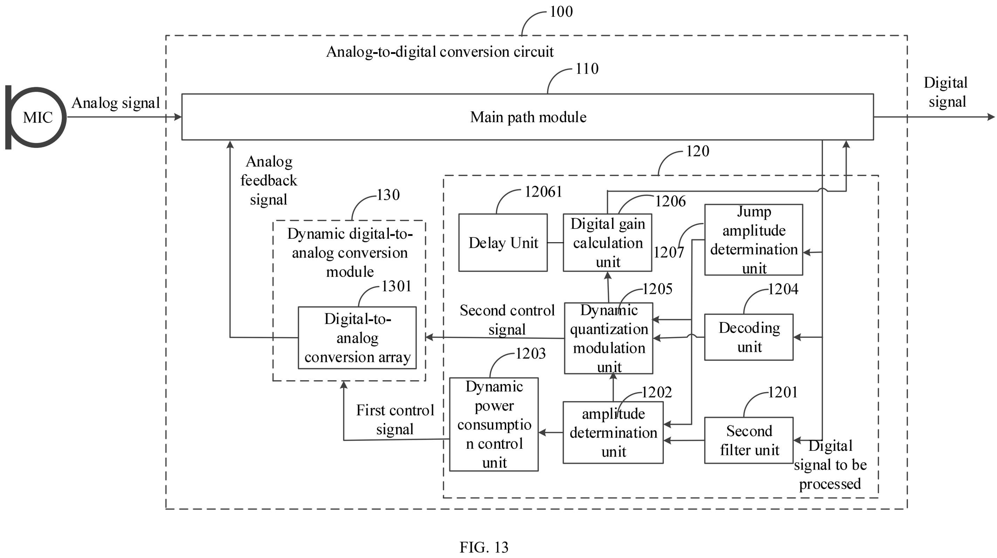

It is understood that to compensate for a signal processing delay of the main path module 110, in some embodiments of the present disclosure, the digital gain calculation unit 1206 further includes a delay unit 12061. As shown in FIG. 13. The delay unit 12061 compensates for the signal processing delay of the main path module 110. After delay compensation, the digital gain signal is output to the main path module 110, improving the accuracy of gain adjustment.

As shown in FIG. 13, in some embodiments, the dynamic range enhancement module 120 further includes a transition amplitude determination unit 1207. When it is detected that an amplitude of a level transition of the digital signal to be processed is greater than a predetermined amplitude threshold, the transition amplitude determination unit 1207 is configured to output a reset signal to the amplitude determination unit 1202, so that the amplitude determination unit 1202 controls the dynamic quantization modulation unit 1205 to reset based on the reset signal. And/or when it is detected that an amplitude of a level transition of the digital signal to be processed is greater than a predetermined amplitude threshold, the transition amplitude determination unit 1207 is configured to output the reset signal to the dynamic quantization modulation unit 1205, so that the dynamic quantization modulation unit 1205 resets in response to the reset signal.

In the embodiment of the present disclosure, the transition amplitude determination unit 1207 functions as an exception handling module. When the amplitude of the level transition of the digital signal to be processed exceeds the predetermined amplitude threshold, it indicates that there may be a possible abnormality in the analog-to-digital conversion circuit 100, the transition amplitude determination unit 1207 outputs the reset signal to the amplitude determination unit 1202, so that the amplitude determination unit 1202 triggers the dynamic quantization modulation unit 1205 to rest in response to the reset signal. For example, the target radix value K is reset to an initial value. Furthermore, the amplitude determination unit 1202 further controls the polling number of the dynamic power consumption control unit 1203 to the total number of the DAC elements in response to the reset signal, so that all of the DAC elements are active.

In another implementation, the transition amplitude determination unit 1207 is configured to directly output the reset signal to the dynamic quantization modulation unit 1205, causing the dynamic quantization modulation unit 1205 to reset in response to the reset signal.

In another implementation, the transition amplitude determination unit 1207 is configured to simultaneously output the reset signal to the amplitude determination unit 1202 and the dynamic quantization modulation unit 1205 to ensure that the dynamic quantization modulation unit 1205 performs a reset operation.

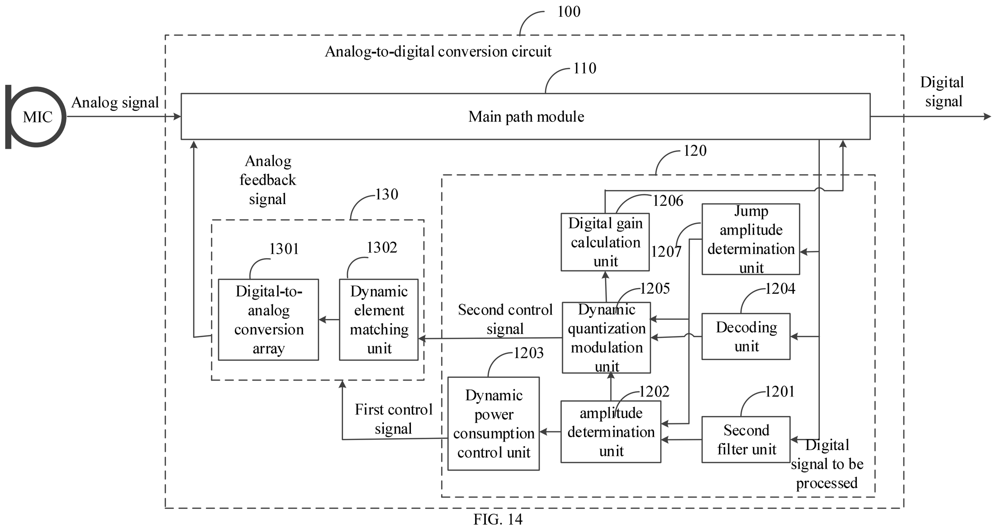

As shown in FIG. 14, in some embodiments, the dynamic digital-to-analog conversion module 130 includes a dynamic element matching unit 1302.

The dynamic element matching unit 1302 is configured to determine a turn-off number of the DAC elements in the digital-to-analog conversion array 1301 according to the first control signal. The dynamic element matching unit 1302 is further configured to control a corresponding number of DAC elements in the digital-to-analog conversion array 1301 to be turned off based on the turn-off number of the DAC elements. The turn-off number of the DAC elements is a difference between the total number of the DAC elements in the digital-to-analog conversion array 1301 and the polling number of the DAC elements.

The dynamic element matching unit 1302 is further configured to dynamically control, according to the second control signal and a dynamic element matching algorithm, enabled DAC elements in the digital-to-analog conversion array 1301 to be turned on in a polling manner based on the turn-on number of the DAC elements, so as to selectively connect to the main path module 110 to form the analog feedback signal.

In the embodiment of the present disclosure, after receiving the first control signal, the dynamic element matching unit 1302 determines the number of the DAC elements in the digital-to-analog conversion array 1301 to be turned off based on the polling number in the first control signal. For example, when the total number of the DAC elements is 200 and the polling number is 100, then the number of the DAC elements to be turned off is 100. Therefore, the dynamic element matching unit 1302 controls 100 of the DAC elements to be turned off.

Then, based on the second control signal and the dynamic element matching algorithm, the remaining 100 DAC elements that are not turned off are dynamically controlled to be turned on and off in the polling manner. For example, when the turn-on number of the DAC elements is t50, in each round, 50 of the 100 DAC elements that are not turned off are selectively turned on and connected to the main path module 110 to form the analog feedback signal.

In the embodiment, the dynamic element matching algorithm is a dynamic element matching algorithm in the related art. Based on the dynamic element matching algorithm, the dynamic element matching unit 1302 averages a usage frequency of the DAC elements in the digital-to-analog conversion array 1301, thereby reducing a performance impact caused by mismatch between DAC elements. It is understood that when the target radix value K is large or the digital signal to be processed is small, the number of the DAC elements that need to be turned on is small, so the number of the DAC elements that needs to be turned off is large. By controlling the dynamic element matching unit 1302 to turn off the DAC elements that are not needed, the power consumption is saved.

Based on the embodiments described above, in a second aspect, the present disclosure provides a chip. The chip includes a chip body and the analog-to-digital conversion circuit 100 described above.

The chip is mounted on an electronic device, such as a microphone signal acquisition device, a wireless microphone, a speaker with recording functionality, or etc.

Because the chip includes the analog-to-digital conversion circuit 100 of the aforementioned embodiments, the chip possesses all functions of the analog-to-digital conversion circuit 100 of the aforementioned embodiments and is not further described herein.

Based on the embodiments described above, in a third aspect, the present disclosure provides a recording device. The recording device includes a device body, a microphone disposed on the device body, and the analog-to-digital conversion circuit 100 described above and the chip described above.

The recording device includes but is not limited to the microphone signal acquisition device, the wireless microphone, the speaker with recording functionality, etc.

Because the recording device includes the analog-to-digital conversion circuit 100 of the aforementioned embodiments, the recording device possesses all functions of the analog-to-digital conversion circuit 100 of the aforementioned embodiments and is not further described herein.

The analog-to-digital conversion circuit of the present disclosure is described in detail below, with reference to specific application scenarios.

### Application Scenario 1

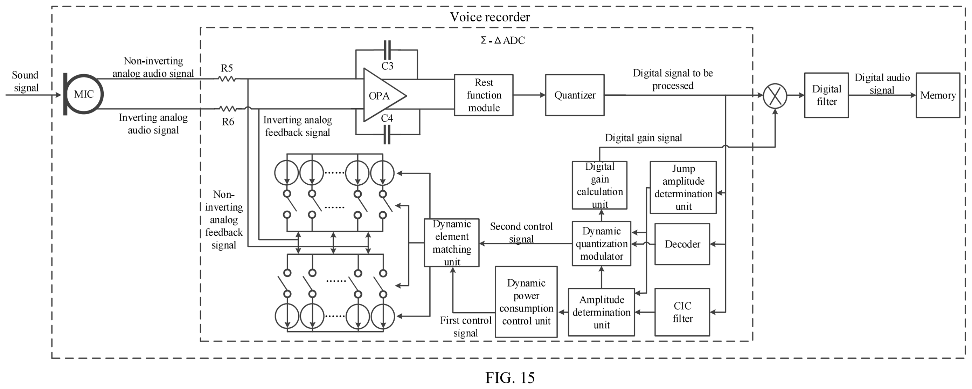

As shown in FIG. 15, which shows a voice recorder. The voice recorder includes a microphone (MIC), a Σ-Δ ADC, and a memory. A main path of the Σ-Δ ADC includes a loop filter and a quantizer. An output end of the microphone (MIC) is connected to an input end of the loop filter. An output end of the quantizer is connected to a digital filter via a multiplier. The output of the digital filter is connected to the memory. The loop filter includes an integrator and rest functional modules. The integrator includes input resistors (R5 and R6), integrating capacitors (C3 and C4), and an operational amplifier (OPA).

The Σ-Δ ADC further includes a dynamic range enhancement module and a dynamic digital-to-analog conversion module. The dynamic range enhancement module includes a transition amplitude determination unit, a decoder, a CIC filter, a digital gain calculation unit, a dynamic quantization modulator, an amplitude determination unit, and a dynamic power consumption control unit. The dynamic digital-to-analog conversion module includes a dynamic element matching unit and a current source array.

A signal processing process in the main path is as follows.

The microphone MIC converts a collected sound signal into a differential analog audio signal and inputs the differential analog audio signal into the loop filter. A non-inverting analog audio signal of the differential analog audio signal is input into a non-inverting input end of the OPA and an inverting analog audio signal of the differential analog audio signal is input into an inverting input end of the OPA. A non-inverting analog feedback signal generated by the current source array is also input into the non-inverting input end of the OPA, and an inverting analog feedback signal generated by the current source array is also input into the inverting input end of the OPA. The differential analog audio signal output by the microphone MIC is gain-adjusted by the non-inverting analog feedback signal and the inverting analog feedback signal.

After the integrator and the rest functional modules perform integration and filtering on input signals, a filtered signal (a first filtered signal) is output to the quantizer. After the quantizer quantizes the filtered signal, the quantizer outputs a digital signal to be processed by the multiplier. The digital gain calculation unit outputs the digital gain signal to the multiplier to perform digital gain adjustment on the digital signal to be processed, a single to be modulated is generated and is sent to the digital filter. After processing by the digital filter, a final digital audio signal is obtained and is sent to the memory for storage.

A process for generating the non-inverting analog feedback signal, the inverting analog feedback signal, and the digital gain signal is as follows.

The digital signal to be processed output by the quantizer is filtered out of high-frequency noise by the CIC filter. A filtered signal (a second filtered signal) is then sent to the amplitude determination unit. The amplitude determination unit performs amplitude detection on the second filtered signal based on a predetermined maximum amplitude threshold, a hysteresis amplitude threshold, and a predetermined duration. In this way, a radix adjustment signal is generated and is sent to the dynamic quantization modulator to adjust the K value of the dynamic quantization modulator and generate a polling number. The polling number is sent to the dynamic power consumption control unit. The dynamic power consumption control unit generates a first control signal based on the polling number and outputs the first control signal to the dynamic element matching unit.

The digital signal to be processed output by the quantizer is subjected to data bit expansion (N) and decoding by the decoder. In this way, a predetermined coded signal is generated and is output to the dynamic quantization modulator. The dynamic quantization modulator adjusts the K value based on the radix adjustment signal and dynamically quantizes the predetermined coded signal by an adjusted K value. Then, a second control signal carrying a turn-on number is generated and output to the dynamic element matching unit. Further, the adjusted K value is output to the digital gain calculation unit.

The digital gain calculation unit generates a digital gain signal based on the adjusted K value from the dynamic quantization modulator. After compensating for a signal processing delay in the main path, the digital gain calculation unit outputs the digital gain signal to the multiplier.

The dynamic element matching unit determines a turn-off number of current sources in the current source array based on a difference between the total number of the current sources and the polling number of the current sources in the first control signal. Based on the turn-off number of the current sources, the dynamic element matching unit controls the corresponding number of the current sources in the current source array to turn off, so that the current sources that are turned off are not used.

The dynamic element matching unit uses a dynamic element matching algorithm to dynamically control the current sources in the current source array to turn on in a polling manner based on the turn-on number of the current sources in the second control signal. That is, switches of the current sources are selectively closed. When the switches are selectively closed, currents from the current sources that are turned off are output to the input end of the OPA through the corresponding switches, so as to form the analog feedback signal.

During the entire process, the transition amplitude determination unit performs abnormality detection on the digital signal to be processed output by the quantizer based on a predetermined amplitude threshold. When it is detected that the amplitude of the level transition of the digital signal to be processed is greater than the predetermined amplitude threshold, a reset signal is output to the amplitude determination unit and the dynamic quantization modulator, so that the amplitude determination unit controls the dynamic quantization modulator to reset and the dynamic quantization modulator is reset in response to the reset signal.

### Application Scenario 2

Different from the voice recorder in the application scenario 1 shown in FIG. 15, in the application scenario, the dynamic power consumption control unit is able to output the first control signal to the current source array, thereby directly controlling the corresponding number of the current sources in the current source array to turn off. At the same time, the dynamic power consumption control unit sends the turn-off number of the current sources to the dynamic element matching unit, so that the dynamic element matching unit dynamically controls the switches of the current sources that are not turned off in the current source array based on the dynamic element matching algorithm and the turn-on number. Therefore, the current sources are selectively connected to the main path to form the analog feedback signal, thereby reducing power consumption.

The above is only the optional embodiments of the present disclosure, and is not intended to limit the present disclosure in any way. Although the present disclosure has been disclosed in the optional embodiments, it is not intended to limit the present disclosure, and those skilled in the art could make some changes or modifications to equivalent embodiments with equivalent changes without departing from the scope of the technical solutions of the present disclosure. However, any modification, equivalent change and modification made to the above embodiments, according to the technical essence of the present disclosure without departing from the content of the technical solution of the present disclosure, still fall within the scope of the technical solutions of the present disclosure.

## Claims

1. An analog-to-digital conversion circuit, comprising:
a main path module;
a dynamic range enhancement module; and
a dynamic digital-to-analog conversion module;
wherein the dynamic digital-to-analog conversion module comprises a digital-to-analog conversion array;
wherein the main path module is configured to:
convert an analog signal and an analog feedback signal from the dynamic digital-to-analog conversion module into a digital signal to be processed,
output the digital signal to be processed to the dynamic range enhancement module, and
obtain a digital signal output according to the digital signal to be processed and a digital gain signal from the dynamic range enhancement module;
wherein the dynamic range enhancement module is configured to:
perform dynamic quantization processing on the digital signal to be processed to obtain at least one control signal,
output the at least one control signal to the dynamic digital-to-analog conversion module, and
generate the digital gain signal and output the digital gain signal to the main path module;
wherein the dynamic digital-to-analog conversion module is configured to:
dynamically control on and off of each of digital-to-analog converter (DAC) elements in the digital-to-analog conversion array according to the at least one control signal, and
output the analog feedback signal to the main path module.

2. The analog-to-digital conversion circuit according to claim 1, wherein the main path module comprises a loop filter and a quantizer;
wherein the loop filter is configured to perform integral filtering processing on the analog signal and the analog feedback signal to obtain a first filtered signal and output the first filtered signal to the quantizer;
wherein the quantizer is configured to perform quantization processing on the first filtered signal to obtain the digital signal to be processed and output the digital signal to the dynamic range enhancement module.

3. The analog-to-digital conversion circuit according to claim 2, wherein the main path module further comprises a multiplier and a digital filter;
wherein the multiplier is configured to obtain a signal to be modulated according to the digital signal to be processed and the digital gain signal and output the signal to be modulated to the digital filter;
wherein the digital filter is configured to filter the signal to be modulated to obtain the digital signal.

4. The analog-to-digital conversion circuit according to claim 2, wherein the main path module further comprises a digital filter;
wherein the digital filter is configured to:
filter the digital signal to be processed and the digital gain signal, and
obtain the digital signal according to a filtered digital signal to be processed and a filtered digital gain signal.

5. The analog-to-digital conversion circuit according to claim 1, wherein the dynamic range enhancement module comprises a filter unit, an amplitude determination unit, a dynamic power consumption control unit, a decoding unit, a dynamic quantization modulation unit, and a digital gain calculation unit;
wherein the filter unit is configured to filter the digital signal to be processed to obtain a second filtered signal and output the second filtered signal to the amplitude determination unit;
wherein the amplitude determination unit is configured to:
perform amplitude detection on the second filtered signal according to a predetermined maximum amplitude threshold and a hysteresis amplitude threshold,
output a radix adjustment signal to the dynamic quantization modulation unit according to an amplitude detection result, and
output a polling number of the DAC elements to the dynamic power consumption control unit, where the polling number represents the number of the DAC elements in the digital-to-analog conversion array that are polled and turned on;
wherein the dynamic power consumption control unit is configured to:
generate a first control signal according to the polling number of the DAC elements, and
output the first control signal to the dynamic digital-to-analog conversion module ;
wherein the decoding unit is configured to:
convert the digital signal to be processed into a predetermined coded signal according to a predetermined data expansion bit number, and
output the predetermined coded signal to the dynamic quantization modulation unit;
wherein the dynamic quantization modulation unit is configured to:
adjust a current output radix value according to the radix adjustment signal to obtain a target radix value,
perform dynamic quantization on the predetermined coded signal by the target radix value to obtain a turn-on number of the DAC elements,
output a second control signal carrying the turn-on number of the DAC elements to the dynamic digital-to-analog conversion module, and
output the target radix value to the digital gain calculation unit, where the turn-on number of the DAC elements is less than the polling number of the DAC elements;
wherein the digital gain calculation unit is configured to obtain the digital gain signal according to the data expansion bit number and the target radix value.

6. The analog-to-digital conversion circuit according to claim 5, wherein the amplitude determination unit is configured to:
output a first adjustment signal to the dynamic quantization modulation unit when an amplitude of the second filtered signal is less than a threshold difference within a predetermined duration, wherein the first adjustment signal is configured to instruct the dynamic quantization modulation unit to adjust the current output radix value, and the threshold difference is a difference between the predetermined maximum amplitude threshold and the hysteresis amplitude threshold;
output a second adjustment signal to the dynamic quantization modulation unit when the amplitude of the second filtered signal is greater than a threshold sum within the predetermined duration, wherein the second adjustment signal is configured to instruct the dynamic quantization modulation unit to adjust the current output radix value, and the threshold sum is a sum of the predetermined maximum amplitude threshold and the hysteresis amplitude threshold; and
output a third adjustment signal to the dynamic quantization modulation unit when the amplitude of the second filtered signal is not less than the threshold difference and not greater than the threshold sum within the predetermined duration, wherein the third adjustment signal is configured to instruct the dynamic quantization modulation unit to maintain the current output radix value.

7. The analog-to-digital conversion circuit according to claim 5, wherein the dynamic range enhancement module further comprises a transition amplitude determination unit;
wherein the transition amplitude determination unit is configured to:
output a reset signal to the amplitude determination unit when it is detected that an amplitude of a level transition of the digital signal to be processed is greater than a predetermined amplitude threshold, so that the amplitude determination unit controls the dynamic quantization modulation unit to reset based on the reset signal, and/or
output the reset signal to the dynamic quantization modulation unit, so that the dynamic quantization modulation unit resets in response to the reset signal.

8. The analog-to-digital conversion circuit according to claim 5, wherein the dynamic digital-to-analog conversion module comprises a dynamic element matching unit;
wherein the dynamic element matching unit is configured to:
determine a turn-off number of the DAC elements in the digital-to-analog conversion array according to the first control signal, and
control a corresponding number of DAC elements in the digital-to-analog conversion array to be turned off based on the turn-off number of the DAC elements, wherein the turn-off number of the DAC elements is a difference between a total number of the DAC elements in the digital-to-analog conversion array and the polling number of the DAC elements, and
dynamically control, according to the second control signal and a dynamic element matching algorithm, enabled DAC elements in the digital-to-analog conversion array to be turned on in a polling manner based on the turn-on number of the DAC elements, so as to selectively connect to the main path module to form the analog feedback signal.

9. The analog-to-digital conversion circuit according to any one of claims 1-8, wherein the digital-to-analog conversion array comprises at least one of a current source array, a resistor array, and a capacitor array.

10. A chip, comprising:
a chip body; and
the analog-to-digital conversion circuit according to any one of claims 1-9, disposed on the chip body.

11. A recording device, comprising:
a device body;
a microphone disposed on the device body;
the analog-to-digital conversion circuit according to any one of claims 1-9; or
the chip according to claim 10.
